# EUROPEAN PATENT APPLICATION

(11) **EP 4 700 150 A1**
(43) Date of publication of application: **25.02.2026**
(21) Application number: 25191147.5
(22) Date of filing: 23.07.2025
(51) Int. Cl.: C23C 16/44, C23C 16/455

(54) **CHEMICAL VAPOR DEPOSITION SYSTEM WITH GAS CURTAIN MODULE AND A METHOD**

(30) Priority: 23.07.2024 FI 20245918
(71) Applicant: Canatu Finland Oy, 01720 Vantaa (FI)
(72) Inventor: KOSKINEN, Tomi, 01720 Vantaa (FI); JUNTUNEN, Taneli, 01720 Vantaa (FI); LAINE, Risto, 01720 Vantaa (FI); SALMI, Emma, 01720 Vantaa (FI); P AZA, Przemys aw, 01720 Vantaa (FI)
(74) Representative: Papula Oy

(57) **Abstract**

Disclosed are a chemical vapor deposition system, a gas curtain module for a gas distribution system of a chemical vapor deposition system, and a method of valve control for such system. The gas distribution system for transferring the deposition product from the reactor to the collection chamber comprises a gas curtain module positioned in the pipeline between the gas flow inlet and the collection valve, wherein the gas curtain module comprises one or more purging gas inlets and is configured to introduce a purging gas into the pipeline at its position.

## Description

### FIELD

The present invention relates to gas flow control for a chemical vapor deposition (CVD) system.

### BACKGROUND

A specific type of chemical vapor deposition (CVD) systems has a reactor for creating a deposition product which is separate from a collection chamber for treatment of the deposition product, and the reactor may be connected to the chamber by a distribution system. In the distribution system, debris may collect and eventually enter into the collection chamber, contaminating the deposition product.

### SUMMARY

It is an objective to provide a system and a method for mitigating the problem of contamination.

For this purpose, a CVD system and a method for controlling the CVD system are presented.

According to a first aspect, a chemical vapor deposition (CVD) system is disclosed. The system comprises several components: a reactor for creating a deposition product, a collection chamber for treatment of the deposition product, and a gas distribution system (GDS) for transferring the deposition product from the reactor to the collection chamber. The deposition product may comprise or consist of nanostructures, such as high-aspect ratio molecular (HARM) structures, which are first created in the reactor by any appropriate method, and then transferred to the collection chamber for treatment via the GDS. The treatment performed in the collection chamber may include deposition, such as chemical vapor deposition, or product collection, isolation, processing in a vacuum system, product removal and any combination thereof. The treatment may provide a CVD product.

The GDS comprises a pipeline connecting the reactor with the collection chamber, the pipeline comprising an inner surface. The GDS also comprises a gas flow inlet connecting the pipeline and the reactor, wherein the gas flow inlet is configured to provide the deposition product from the reactor into the pipeline. The GDS further comprises a collection valve positioned between the pipeline and the collection chamber, the collection valve configured to provide the deposition product from the pipeline into the collection chamber; and a gas curtain module positioned in the pipeline between the gas flow inlet and the collection valve. The gas curtain module comprises one or more purging gas inlets and is configured to introduce a purging gas into the pipeline at its position. The gas curtain module may also comprise one or more valves to provide the gas into the one or more purging gas inlets, and extension pipes if any of the components of the gas curtain module are spaced apart. The gas curtain module can effectively serve as a gas curtain which, when comprised in a CVD system, can reduce the amount of debris collected past the gas curtain module in the pipeline. In addition, the CVD system of the first aspect having a gas curtain module can help flush the unwanted debris from portions of the pipeline.

In an embodiment, the GDS also comprises a gas flow outlet valve arranged in the pipeline between the gas flow inlet and the gas curtain module. In an additional embodiment, the GDS can comprise an additional gas curtain module positioned between the gas flow inlet and the outletvalve, which prevents the collection of debris at the gas flow outlet valve.

According to an embodiment, the gas flow outlet valve is connected to a waste outlet. This creates an additional possible gas flow stream from the gas flow inlet to the waste outlet.

In an alternative embodiment, the gas flow outlet valve is connected to a second collection chamber for treatment of the deposition product for providing a CVD product. This creates a possibility for treatment in two collection chambers, either simultaneously or in sequence. An effect of the setup with two or more collection chambers can be reduced cycle time. When collection ends and the CVD product is being unloaded from the first chamber, the second chamber can be active in the meantime. As in the prior embodiments, the GDS can comprise an additional gas curtain module positioned between the gas flow inlet and the outlet valve, and the two gas curtain modules can support the flow of gas in two directions, e.g. from the gas flow inlet into either of the collection chambers - while preventing the formation of debris in the closed off direction.

According to an embodiment, the purging gas is an inert gas selected from the group of: nitrogen, argon and helium. Inert gases may be preferred as purging gases of the gas curtain module because they are less likely to react with any of the chemicals introduced with the gas flow.

In an embodiment, the gas curtain module comprises a buffer area arranged to distribute the purging gas provided from the one or more purging gas inlets before it is introduced into the pipeline. The buffer area may fill up at least partially with purging gas before it is released into the pipeline, making the introduction of purging gas more uniform.

In a further embodiment, the buffer area has a shape which follows a portion of the inner surface of the gas curtain module and comprises an inner surface facing inside the pipeline. In this embodiment, the buffer area can be shaped for example similar to the inner surface of the pipeline, and positioned inside of the pipeline or around its circumference facing inwards.

In a further embodiment, the buffer area of the gas curtain module comprises at least one slit located on the inner surface of the buffer area, the at least one slit arranged to introduce the purging gas from the buffer area into the pipeline. The slit can help introduce the purging gas into the pipeline more evenly along the length of the slit. In some embodiments, the slit may be positioned differently, for example it can follow the inner surface of the buffer area circumferentially or be positioned along the direction of the gas flow inside of the pipeline, or at an angle between the two positions.

In an embodiment alternative to the above, the buffer area of the gas curtain module can comprise at least 4 openings located in pairs and opposite each other on the inner surface of the buffer area, the openings arranged to introduce the purging gas from the buffer area into the pipeline. As an alternative to the slits, the purging gas may be introduced via a number of openings.

According to an embodiment, the pipeline has a circular cross-section, and the gas curtain module is configured to introduce the purging gas into the pipeline along the radial perimeter of the cross-section of the pipeline. This configuration with a circular cross-section of the inner surface of the pipeline provides a substantially circular gas curtain module that can introduce the purging gas evenly at specific points in the pipeline.

In an alternative embodiment, the pipeline has a rectangular cross-section, and the gas curtain module is configured to introduce the purging gas into the pipeline along the rectangular perimeter of the cross-section of the pipeline.

In an embodiment, the gas flow inlet is a gate valve.

According to an embodiment, the system of the first aspect further comprises one or more controllers for controlling the gas flow inlet, the collection valve, the gas flow outlet valve and the gas curtain module. The controllers may be configured to direct gas flow by controlling the mentioned valves. In a further embodiment, the one or more controllers are configured to have the gas curtain module open while the gas flow inlet and outlet valves are open, but the collection valve is closed. In this embodiment, when the collection valve is closed, the gas flow coming through the inlet valve is directed towards the outlet valve, while the gas curtain module prevents the formation of debris near the closed collection valve. This can be combined with any other flushing techniques and configurations.

According to an embodiment, the gas curtain module is positioned at a distance of 0-100 centimeters from the collection valve. The choice of distance from the collection valve may be based on the overall pipeline structure, configuration, gas flow speeds and other parameters.

In an embodiment, the gas curtain module is positioned transversely in relation to the direction of gas flow in the pipeline. This configuration can provide a transverse introduction of the purging gas, which be efficient for .

In an alternative embodiment, the gas curtain module is positioned at an angle between 1 and 90 degrees in relation to the direction of gas flow in the pipeline. An angled position of the gas curtain module may be beneficial in some pipeline configurations and can help with purging debris from the pipeline.

In an embodiment, the GDS comprises a bypass valve. The bypass valve is positioned such that a bypass mode can be activated wherein the gas flowing from the gas flow inlet for the collection chamber is directed through the bypass valve and partially or fully blocked from passing through the collection valve. In further embodiments, the bypass valve may be connected to a bypass arm of the pipeline.

According to embodiments, the CVD system can be a floating-catalyst chemical vapor deposition (FCCVD) system, or any other aerosol CVD system.

In an embodiment, the system further comprises a viewport connected to the pipeline with a secondary arm, and a second gas curtain module positioned between the viewport and the connection point of the secondary arm with the pipeline, wherein the second gas curtain module comprises one or more purging gas inlets and is configured to introduce a purging gas into the secondary arm at its position. The second gas curtain module can be the same or different from the first gas curtain module, and it also provides an effect of preventing debris formation in the secondary arm, e.g. near the viewport.

According to a second aspect, a gas curtain module for a gas distribution system of a chemical vapor deposition (CVD) system is provided. The gas curtain module is positioned in a pipeline of the gas distribution system, and comprises: one or more inlets configured to introduce a purging gas, a buffer area connected to the one or more inlets and arranged to distribute the purging gas provided from the one or more purging gas inlets before it is introduced into the pipeline, and at least one slit and/or four or more openings arranged to provide gas flow of the purging gas from the buffer area into the pipeline.

In an embodiment of the second aspect, the four or more openings are positioned in pairs at opposite sides of the pipeline in a plane perpendicular to the gas flow direction in the pipeline.

What is stated above regarding the first aspect applies also to the second aspect, including various embodiments and combinations of features that relate to gas curtain modules.

According to a third aspect, a method of valve control for a chemical vapor deposition (CVD) system is provided. The system includes a reactor for creating a deposition product, a collection chamber treatment of the deposition product and a gas distribution system (GDS) for transferring the deposition product from the reactor to the collection chamber. The method comprises having a gas flow inlet of the GDS connecting the reactor and the GDS and a gas flow outlet valve between the gas flow inlet and the gas curtain module of the GDS open, while a collection valve for the GDS is closed, for cycling the deposition product without it reaching the collection chamber, and thereafter, having the gas flow inlet and the collection valve open, while the gas flow outlet is closed, so the deposition product from the reactor is directed without debris to the collection chamber for treatment to provide a CVD product. The gas flow outlet valve may be connected to an exhaust, in which case the cycling of the deposition product may be performed to flush and clean the GDS from debris. Using the gas curtain module during cycling of the deposition product without it reaching the collection chamber can have an effect of preventing the debris from forming past the gas curtain module in the GDS.

In an embodiment, the collection chamber may have an exhaust valve, and the collection valve can be open together with the exhaust valve of the collection chamber for directing the deposition product from the reactor to the collection chamber for the treatment.

The method of valve control according to the third aspect and any of its embodiments may be implemented as a computer program which, when executed on a computer, performs the steps of the method.

What is stated above regarding the first aspect applies also to the third aspect.

For the CVD systems as disclosed, volumes of recirculating gas flow may be developed in the gas distribution system (GDS). This recirculating gas flow can result in accumulation of debris, which may be released into the collection chamber and contaminate it.

The disclosed solutions provide a GDS configuration which comprises one or more gas curtain modules, which allow preventing the debris from forming and accumulation in the GDS, e.g. in positions next to closed valves where it often accumulates first. The configuration can also help flush parts of the GDS that would not be flushed under normal operation of the system. The presented system, gas curtain module and method can result in a reduced amount of debris in the collection chamber and therefore also on the product fabricated in the reactor, improving purity and quality of the resulting CVD product.

It should be noted that all instances of a valve being "open" herein may refer to said valve being partially open or said valve being fully open. Similarly, all instances of a valve being "closed" herein may refer to said valve being partially closed or said valve being fully closed.

It is to be understood that the aspects and embodiments described above may be used in any combination with each other. Several of the aspects and embodiments may be combined together to form a further embodiment of the invention.

### BRIEF DESCRIPTION OF THE DRAWINGS

The accompanying drawings, which are included to provide a further understanding and constitute a part of this specification, illustrate examples and together with the description help to explain the principles of the disclosure. In the drawings:
**Figs. 1A-B** are schematic illustrations of a chemical vapor deposition (CVD) system according to examples,
**Fig. 2** illustrates the components of a gas distribution system (GDS) according to an example,
**Figs. 3A-3B** illustrate a gas curtain module according to an example,
**Fig. 4** illustrates a gas curtain module according to another example,
**Fig. 5** illustrates a GDS connected to two collection chambers according to an example, and
**Fig. 6** is a diagram of a method according to an example.

Like references are used to designate equivalent or at least functionally equivalent parts in the accompanying drawings.

### DETAILED DESCRIPTION

The detailed description provided below in connection with the appended drawings is intended as a description of examples and is not intended to represent the only forms in which the example may be constructed or utilized. However, the same or equivalent functions and structures may be accomplished by different examples.

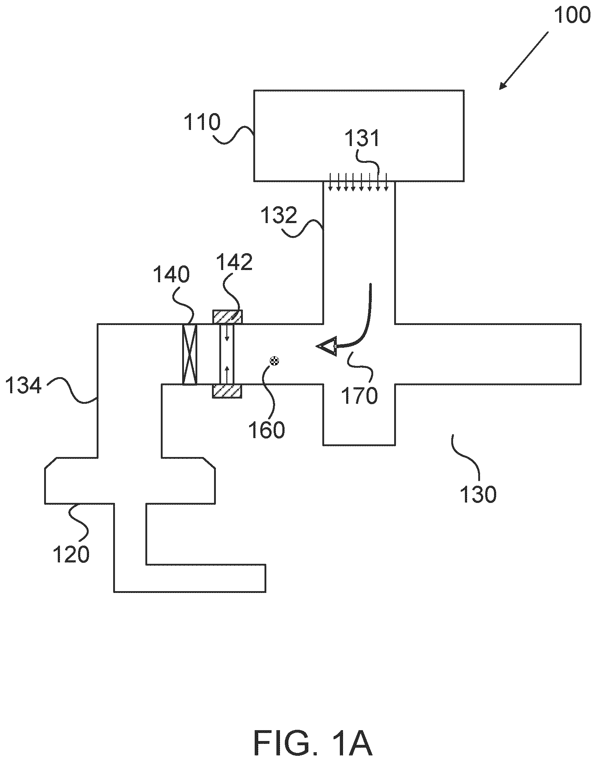

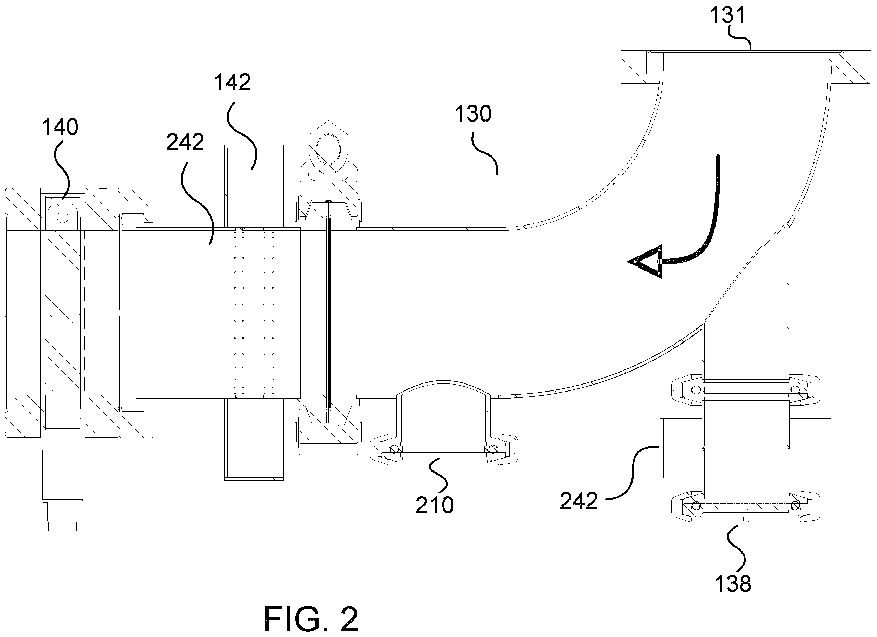

Figs. 1A-B schematically illustrate chemical vapor deposition (CVD) systems (hereinafter "the system" refers to the CVD system) according to an example, while Fig. 2 is a more detailed schematic illustration of an example gas distribution system (GDS). It is noted that the CVD system may be a floating-catalyst chemical vapor deposition (FCCVD) system, or an aerosol CVD system. The

The system 100 comprises a reactor 110, such as a FCCVD reactor, which may be configured for creating a deposition product. The reactor may be configured for creating the deposition product with the help of a catalyst, such as an aerosol. The system also comprises a collection chamber 120, which may be configured for treatment of the deposition product. The treatment performed in the collection chamber 120 may include deposition, such as chemical vapor deposition, or product collection, isolation, processing in a vacuum system, product removal and any combination thereof. The deposition product may comprise or consist of nanostructures, such as high-aspect ratio molecular (HARM) structures. The HARM structures may have length 50-10000 times or larger than their maximum diameter. In this sense, they may be considered substantially one-dimensional structures. The HARM-structures may comprise or consist of carbon nanostructures, for example carbon nanotubes (CNTs), such as single-walled CNTs and/or multi-walled CNTs, carbon nano-buds (molecule having a fullerene molecule covalently bonded to the side of a carbon nanotube), carbon nanoribbons, or any combination thereof. Alternatively or additionally, the HARM-structures may comprise other types of HARM-structures such as cellulose fibers, nanorods or nanowires, e.g. silver nanowires or III-V nanowires. The HARM-structures may comprise or consist of uncoated structures and/or coated structures, such as coated CNTs. The deposition product may be deposited in a substantially planar network of the HARM-structures. The HARM-structures may be oriented substantially randomly in the network. The HARM-structures may be electrically conductive HARM-structures.

The system 100 comprises a gas distribution system (GDS) 130, which may be configured for transferring the deposition product from the reactor 110 to the collection chamber 120. The GDS 130 comprises a pipeline which may have multiple "arms" - this term is sometimes used for clearer understanding of the Figures; however, the arms should not be perceived as limiting features since the pipeline may have various structures. Gas supply through any or all of the arms may be controlled by a valve situated at the corresponding arm. For example, the GDS comprises a path from the reactor to the collection chamber and this may be formed by one, two or more arms. A reactor arm 132 may be provided for transferring the deposition product from the reactor and this arm may be connected, directly or indirectly to a collection arm 134 for transferring the deposition product to the collection chamber. The reactor arm and the collection arm may also be joined as a single monolithic arm. In such a case, the reactor arm may correspond to a reactor-side region of the monolithic arm and the collection arm to a chamber-side region of the monolithic arm.

The pipeline connecting the reactor with the collection chamber comprises an inner surface.

The system 100 may comprise a gas flow inlet 131, which may include a gate valve or any other valve. It is configured to provide the deposition product from the reactor into the pipeline to then be delivered to the collection chamber 120. The gas flow inlet 131 may be considered as part of the GDS.

The system 100 may comprise a collection valve 140, which may also be considered as part of the GDS. The collection valve 140 may be positioned between the pipeline and the collection chamber, for example at the end of the collection arm. The collection valve may be configured to, in an open position, partially or fully permit gas flow which helps provide the deposition product from the reactor 110 to the collection chamber 120. The system may also be configured to include a gas flow outlet valve, such as an exhaust valve, as defined below. The collection valve 140 may be configured for, in a closed position, partially or fully blocking gas flow for preventing transmission of the deposition product from the reactor to the collection chamber. The collection valve may be a control valve, such that it can assume one or more positions between a maximally open position and a maximally closed position, for example continuously. The collection valve may also be any other suitable type of valve.

The system 100 may comprise a gas curtain module 142 positioned in the pipeline between the gas flow inlet 131 and the collection valve 140, wherein the gas curtain module 142 comprises one or more purging gas inlets and is configured to introduce a purging gas into the pipeline at its position. The gas flow inlets are schematically illustrated with arrows inside of the gas curtain module 142, however the structure is not limited to what is shown in Figs. 1A-1B as the gas curtain module may have a buffer zone and any suitable configuration, as shown in more detail below. The gas curtain module 142 can effectively serve as a gas curtain which, when comprised in a CVD system, can reduce the amount of debris collected past the gas curtain module in the pipeline. In addition, the CVD system 100 having a gas curtain module 142 can help flush the unwanted debris from portions of the pipeline.

The pipeline may have a circular, rectangular or any other suitable cross-section, and the pipeline comprises an inner surface. The shape of the gas curtain module 142 may follow at least a portion of the inner surface of the pipeline at its location.

Debris 160 may accumulate between the collection valve and the bypass valve. In particular, debris 160 may accumulate at the collection valve 140, on the side of the reactor. The GDS configuration comprising at least one gas curtain module 142 as disclosed herein allows preventing such debris from entering the collection chamber 120.

The arrow 170 in Figs. 1A-1B generally illustrates the direction of deposition product from the gas flow inlet 131 to the collection chamber 120. This direction is normally arranged when the collection valve 140 is open and the gas curtain module 142 permitting the gas flow through, which allows treatment at the collection chamber 120. Configurations of the GDS 130 allow for different gas flow directions, and the gas curtain module 142 can prevent accumulation of debris in modes wherein the direction is different, so that when the deposition product eventually flows along the direction 170, the amount of debris entering the collection chamber 120 is significantly reduced.

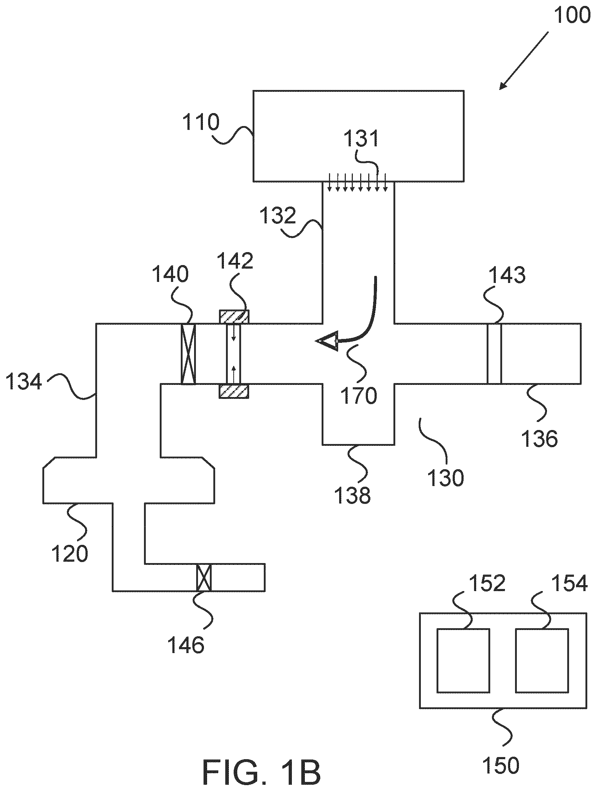

As shown in Fig. 1B, the system may also comprise a bypass arm 136 for directing gas flow in a direction away from the reactor and the collection chamber. The bypass arm may be configured for directing gas in a direction away from the reactor and from the collection chamber to a bypass exhaust. A filter may be situated at the bypass exhaust for collecting the deposition product, which may afterwards be discarded. The bypass arm may be considered a part of the GDS. The system may also comprise a bypass valve 143, which may be considered as part of the GDS. It allows bypass of the collection chamber, or the collection arm altogether. The bypass valve 143 may be located away from the reactor and the collection chamber, in particular at the bypass arm. The bypass valve 143 may be configured for allowing gas flow from the reactor to bypass the collection chamber. The bypass valve may be configured for, in an open position, partially or fully permitting gas flow for facilitating transmission of the deposition product from the reactor to the bypass exhaust. The bypass valve 143 may be configured for, in a closed position, partially or fully blocking gas flow for preventing transmission of the deposition product from the reactor to the bypass exhaust.

The arms illustrated on Figs. 1A-1B arm may extend away from each other, for example from a common origin. They may be arranged in a T-shaped pattern. The GDS may also comprise a monitoring and/or cleaning window 138, for example at an extension arm of the GDS.

The system may also comprise a collection chamber exhaust valve 146, shown on Fig. 1B. The collection chamber exhaust valve 146 may also be considered as part of the GDS. The valve 146 may be located at the collection chamber or downstream from the collection chamber, e.g. at the collection arm. It may be configured for facilitating removal of gas from the collection chamber 120, in particular in a direction away (along a gas transmission path) from the collection valve 140. The exhaust valve may be configured for, in an open position, partially or fully permitting gas flow for facilitating removal of gas from the collection chamber. The exhaust valve may be configured for, in a closed position, partially or fully blocking gas flow for preventing removal of gas from the collection chamber through the exhaust valve. The collection chamber exhaust valve 146 may be a control valve, such that it can assume one or more positions between a maximally open position and a maximally closed position, for example continuously. This allows adjusting the degree of openness for the valve 146. Passage of gas to and from the collection chamber may be controlled, at least, by the exhaust valve and/or the collection valve.

The system may comprise one or more controllers 150 for controlling any or all of the valves, as shown in Fig. 1B as a separate module. This applies to any or all of the following: the gas flow inlet 131 if it is implemented as a valve, the bypass valve 143, the collection valve 140, the gas curtain module 142 and any of the exhaust valves. The one or more controllers may comprise one or more processors 152 for this purpose. For the same purpose, the one or more controllers may also comprise one or more memories 154. The one or more memories may comprise instructions which, when the instructions are executed by the one or more processors, cause any of the actions related to valve control as disclosed herein to be performed. The one or more controllers may be configured for controlling any or all of the valves through a wired connection and/or a wireless connection.

Any or all of the valves mentioned herein may be electrically, pneumatically or hydraulically controllable valves. As such, any or all of the valves may be provided as automated valves or actuated valves. Any or all of the valves may incorporate an actuator to auto-mate the opening, closing, or modulation of the valve based on external signals or commands, in particular from the one or more controllers. The actuator may be powered by any combination of electricity, compressed air (pneumatics) and compressed fluid (hydraulics). In particular, as mentioned, any or all of the valves may be control valves, such as throttling valves. This allows them to be controlled into one or more intermediate positions between fully open and fully closed. Any or all of the valves may be configured so that such control can be made stepwise and/or continuously. Any or all of the valves may be configured to allow for incremental adjustments to the valve position, enabling fine control over gas flow at said valve(s). Control valves with throttling valves in particular allow maintaining a specific flow rate.

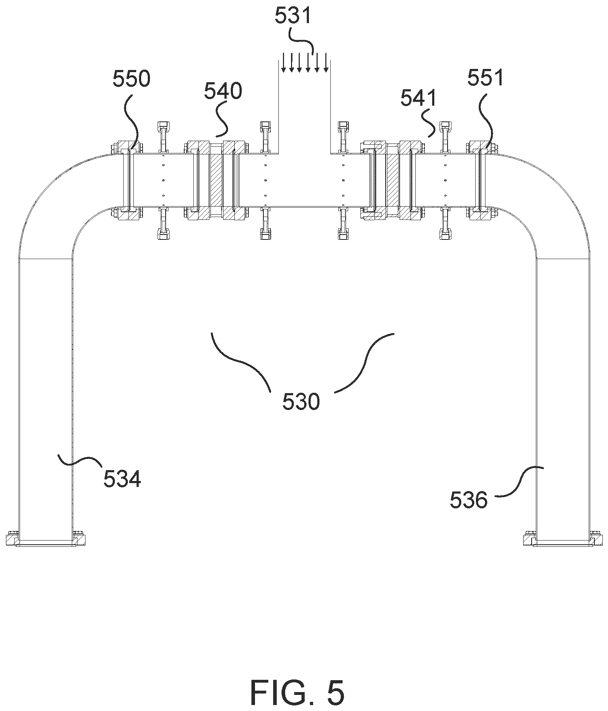

Fig. 2 illustrates an example layout of a GDS 130. In this example, the GDS 130 includes a pipeline with an inner surface as can be seen in the drawing, a gas flow inlet 131, a collection valve 140 and a gas curtain module 142. In addition, the GDS in this example includes a gas flow outlet valve 210 arranged between the gas flow inlet 131 and the gas curtain module 142. The gas flow outlet valve 210 can be connected to a waste outlet or an exhaust, making it an exhaust valve, or to a second collection chamber for treatment of the deposition product. The gas flow outlet valve 210 provides an alternative gas flow direction when the collection valve 140 is closed, which may be used in operational cycles such as flushing or any other cycle that is not treatment, wherein the deposition product needs to reach the collection chamber past the collection valve 140. In such alternative operational cycles or modes debris may accumulate at certain points in the pipeline, for example close to the collection valve 140. The gas curtain module 142 helps minimize accumulation of such debris, as described in this specification. The example of the gas flow outlet valve 210 leading into a second collection chamber is detailed below in connection with Fig. 5.

In Fig. 2 the GDS 130 further comprises a monitoring and/or cleaning window 138 at an extension arm. The window 138 can be configured to monitor the gas flow or to allow access for cleaning. As the extension arm with the window can create a further point of debris collection, in some examples a second gas curtain module 242 can be positioned at a position between the gas flow inlet 131 and the window 138.

The gas curtain module 142 can create a volume between its position in the pipeline and the collection valve. The gas flown through the gas curtain module 142 produces a local pressure increase that blocks gas flow from the gas flow inlet side from entering the volume between the collection valve 140 and the gas curtain module 142, reducing the amount of debris accumulating into this volume. The gas curtain module 142 includes one or more purging gas inlets that introduce an inert purging gas such as nitrogen or argon. The gas curtain module 142 may also comprise a buffer area 242 arranged to distribute the purging gas provided from the one or more purging gas inlets before it is introduced into the pipeline. In the example shown in Fig. 2, the buffer area 242 follows circumferentially the shape of the inner surface of the pipeline. The buffer area 242 can itself have an inner surface facing inside the pipeline, and the inner surface of the buffer area 242 is arranged to introduce the purging gas into the pipeline via openings or slits or any other appropriate means.

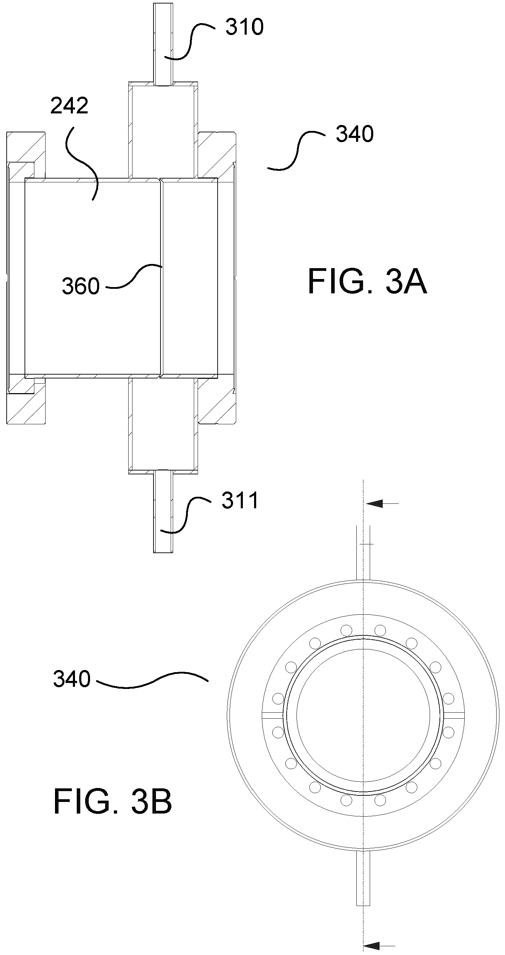

Figs. 3A-3B illustrate an example of the gas curtain module 340 arranged with a slit 360 at the inner surface of its buffer area 242 that follows the circumference of the pipeline. Fig. 3A is a side-view of the gas curtain module 340, while Fig. 3B provides a transverse cross-section. This configuration creates a ring-shaped gas curtain module outputting a radially uniform gas flow into the pipeline, facilitating the effect of local pressure increase that blocks gas flow from the gas flow inlet side. The slit 360 may follow the circumference or be localized to portions of the inner surface. In other examples, the gas curtain module 340 may include two or more slits positioned at a distance from each other, at various angles.

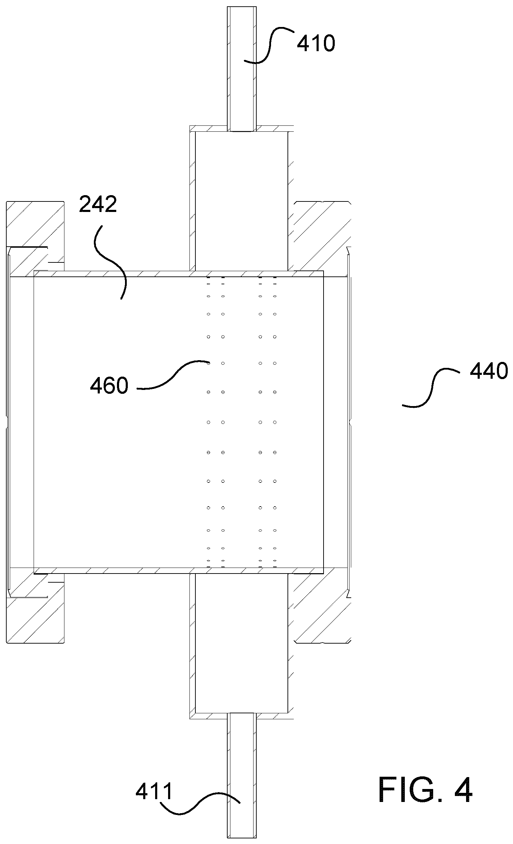

Fig. 4 illustrates an example of the gas curtain module 440 arranged with openings 460 at the inner surface of its buffer area 242 that follow the circumference of the pipeline. The buffer area 242 of the gas curtain module 440 connected to the purging gas inlets 410, 411 is thereby arranged to distribute the purging gas provided from the inlets 410, 411 before it is introduced into the pipeline via the openings 460.

The gas curtain modules 340 and 440 are illustrated with two purging gas inlets 310, 311 and 410, 411, however other configurations are possible, for example with one purging gas inlet or with several purging gas inlets positioned radially.

Fig. 5 illustrates an example GDS 530 that comprises two pipeline arms 534, 536 leading into two collection chambers (not shown in the Figure), allowing for treatment of the deposition product in two collection chambers either simultaneously or in sequence. An effect of the setup shown in Fig. 5 can be reduced cycle time. When one of the pipeline arms 534, 536 is not in use for any reason, such as due to a deposited product being unloaded from a collection chamber, the other pipeline (and collection chamber) can be active in the meantime. The GDS 530 comprises a gas flow inlet 531, two gas curtain modules 540, 541 and two collection valves 550, 551. One of the collection valves 550, 551 may also be considered as an outlet valve that is connected to a secondary collection chamber.

Successful operation of the system does not require the structure to be exactly as shown in the Figures, and any of its elements may be replaced with suitable alternatives, keeping the main components as they are defined in this specification.

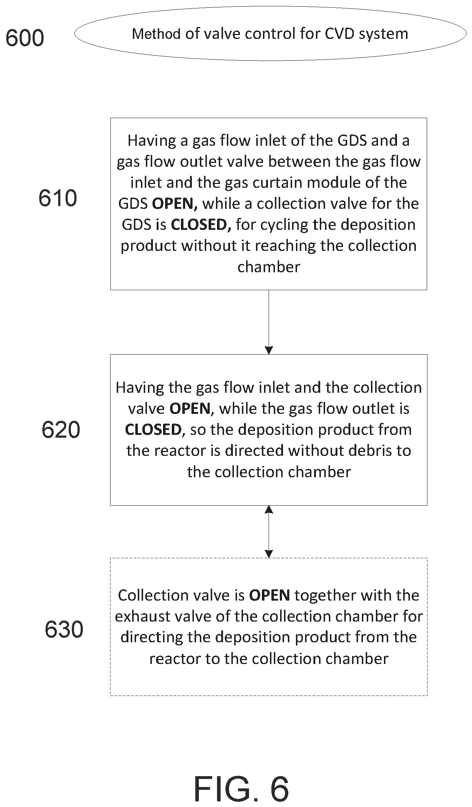

Fig. 6 illustrates an example of a method 600. In the method, one or more of the steps may be performed at the same time or in different order. The method may be utilized for any of the systems as disclosed herein.

The method 600 is a method of valve control for a chemical vapor deposition (CVD) system having a reactor for creating a deposition product, a collection chamber for treatment of the deposition product e.g. to produce a CVD product, and a gas distribution system (GDS) for transferring the deposition product from the reactor to the collection chamber. The CVD system can be any of the systems described in the examples above.

The method comprises having 610 a gas flow inlet of the GDS connecting the reactor and the GDS and a gas flow outlet valve between the gas flow inlet and the gas curtain module of the GDS open, while a collection valve for the GDS is closed, for cycling the deposition product without it reaching the collection chamber, and thereafter having 620 the gas flow inlet and the collection valve open, while the gas flow outlet is closed, so the deposition product from the reactor is directed without debris to the collection chamber for treatment. This results in alternation of operational modes, wherein the gas curtain module being open in the step 610 significantly reduces the amount of debris accumulated at the collection valve, so that during the transfer at step 620 the deposition product can reach the collection chamber without debris.

In an example wherein the collection chamber of the CVD system comprises an exhaust valve, the method 600 can also comprise an optional step of having 630 the collection valve open together (simultaneously) with the exhaust valve of the collection chamber for directing the deposition product from the reactor to the collection chamber for the treatment.

The different functions discussed herein may be performed in a different order and/or concurrently with each other.

Any range or device value given herein may be extended or altered without losing the effect sought, unless indicated otherwise. Any example may be combined with another example unless explicitly disallowed.

Although the subject matter has been described in language specific to structural features and/or acts, it is to be understood that the subject matter defined in the appended claims is not necessarily limited to the specific features or acts de-scribed above. Rather, the specific features and acts described above are disclosed as examples of implementing the claims and other equivalent features and acts are intended to be within the scope of the claims.

It will be understood that the benefits and advantages described above may relate to one embodiment or may relate to several embodiments. The embodiments are not limited to those that solve any or all of the stated problems or those that have any or all of the stated benefits and advantages. It will further be understood that reference to 'an' item may refer to one or more of those items.

The term 'comprising' is used herein to mean including the method, blocks or elements identified, but that such blocks or elements do not comprise an exclusive list and a method or apparatus may contain additional blocks or elements.

Numerical descriptors such as 'first', 'second', and the like are used in this text simply as a way of differentiating between parts that otherwise have similar names. The numerical descriptors are not to be construed as indicating any particular order, such as an order of preference, manufacture, or occurrence in any particular structure.

Although the invention has been described in conjunction with a certain type of apparatus and/or method, it should be understood that the invention is not limited to any certain type of apparatus and/or method. While the present inventions have been described in connection with a number of examples, embodiments and implementations, the present inventions are not so limited, but rather cover various modifications, and equivalent arrangements, which fall within the purview of the claims. Although various examples have been described above with a certain degree of particularity, or with reference to one or more individual embodiments, those skilled in the art could make numerous alterations to the disclosed examples without departing from the scope of this specification.

## Claims

1. A chemical vapor deposition (CVD) system comprising:
- a reactor for creating a deposition product,
- a collection chamber for treatment of the deposition product,
- a gas distribution system (GDS) for transferring the deposition product from the reactor to the collection chamber, the GDS comprising:
• a pipeline connecting the reactor with the collection chamber, the pipeline comprising an inner surface,
• a gas flow inlet connecting the pipeline and the reactor, the gas flow inlet configured to provide the deposition product from the reactor into the pipeline,
• a collection valve positioned between the pipeline and the collection chamber, the collection valve configured to provide the deposition product from the pipeline into the collection chamber,
• a gas curtain module positioned in the pipeline between the gas flow inlet and the collection valve, wherein the gas curtain module comprises one or more purging gas inlets and is configured to introduce a purging gas into the pipeline at its position.

2. The system of claim 1, wherein the GDS also comprises a gas flow outlet valve arranged in the pipeline between the gas flow inlet and the gas curtain module.

3. The system of claim 2, wherein the gas flow outlet valve is connected to a waste outlet.

4. The system of claim 2, wherein the gas flow outlet valve is connected to a second collection chamber for treatment of the deposition product.

5. The system of any one of claims 1-4 , wherein the purging gas is an inert gas selected from the group of: nitrogen, argon and helium.

6. The system of any one of claims 1-5, wherein the gas curtain module comprises a buffer area arranged to distribute the purging gas provided from the one or more purging gas inlets before it is introduced into the pipeline.

7. The system of claim 6, wherein the buffer area has a shape which follows a portion of the inner surface of the gas curtain module and comprises an inner surface facing inside the pipeline.

8. The system of claim 7, wherein the buffer area of the gas curtain module comprises at least one slit located on the inner surface of the buffer area, the at least one slit arranged to introduce the purging gas from the buffer area into the pipeline.

9. The system of claim 7, wherein the buffer area of the gas curtain module comprises at least 4 openings located in pairs and opposite each other on the inner surface of the buffer area, the openings arranged to introduce the purging gas from the buffer area into the pipeline.

10. The system of any one of claims 1-9, wherein the pipeline has a circular cross-section, and the gas curtain module is configured to introduce the purging gas into the pipeline along the radial perimeter of the cross-section of the pipeline.

11. The system of any one of claim 1-9, wherein the pipeline has a rectangular cross-section, and the gas curtain module is configured to introduce the purging gas into the pipeline along the rectangular perimeter of the cross-section of the pipeline.

12. The system of any one of claims 1-11, wherein the gas flow inlet is a gate valve.

13. The system of any one of claims 2-11, comprising one or more controllers for controlling the gas flow inlet, the collection valve, the gas flow outlet valve and the gas curtain module.

14. The system of claim 13, wherein the one or more controllers are configured to have the gas curtain module open while the gas flow inlet and outlet valves are open, but the collection valve is closed.

15. A gas curtain module for a gas distribution system of a chemical vapor deposition (CVD) system, positioned in a pipeline of the gas distribution system, the gas curtain module comprising:
- one or more inlets configured to introduce a purging gas,
- a buffer area connected to the one or more inlets and arranged to distribute the purging gas provided from the one or more inlets before it is introduced into the pipeline, and
- at least one slit and/or four or more openings arranged to provide gas flow of the purging gas from the buffer area into the pipeline.

16. A method of valve control for a chemical vapor deposition (CVD) system having a reactor for creating a deposition product, a collection chamber for treatment of the deposition product, and a gas distribution system (GDS) for transferring the deposition product from the reactor to the collection chamber, the method comprising:
- having a gas flow inlet of the GDS connecting the reactor and the GDS and a gas flow outlet valve between the gas flow inlet and the gas curtain module of the GDS open, while a collection valve for the GDS is closed, for cycling the deposition product without it reaching the collection chamber, and thereafter,
- having the gas flow inlet and the collection valve open, while the gas flow outlet is closed, so the deposition product from the reactor is directed without debris to the collection chamber for deposition.

17. The method of claim 16, wherein the collection chamber has an exhaust valve, and the collection valve is open together with the exhaust valve of the collection chamber for directing the deposition product from the reactor to the collection chamber for the treatment.
